# EUROPEAN PATENT APPLICATION

(11) **EP 4 773 510 A1**
(43) Date of publication of application: **08.07.2026**
(21) Application number: 25158188.0
(22) Date of filing: 17.02.2025
(51) Int. Cl.: H03K 5/156

(54) **DUTY CYCLE CORRECTION**

(30) Priority: 03.01.2025 IN 202541000619
(71) Applicant: NXP B.V., 5656 AG Eindhoven (NL)
(72) Inventor: PANIGRAHI, Chinmayee Kumari, 5656AG Eindhoven (NL); SINGH, Prashant, 5656AG Eindhoven (NL); CHUGH, Aman, 5656AG Eindhoven (NL); SRIVASTAVA, Abhinav, 5656AG Eindhoven (NL); ., SWATI, 5656AG Eindhoven (NL)
(74) Representative: Schwarzweller, Thomas

(57) **Abstract**

The disclosure relates to duty cycle correction of digital data in a CML transmission system. Example embodiments include a CML transmission system (600) comprising: a transmission channel (601) with a transmitter (602) connected to a first end (604) and a receiver (603) connected to a second end (605). A control system (606) is configured to measure a duty cycle of a received signal from the receiver (603) and provide first and second termination resistance control signals (RSTP, RSTN) to respective first and second adjustable receiver termination resistances (501, 502) of the receiver (603) to adjust a balance of the termination resistance control signals (RSTP, RSTN) dependent on a comparison between the measured duty cycle and a nominal duty cycle.

## Description

### Field

The disclosure relates to duty cycle correction of digital data in a CML transmission system.

### Background

Current-mode logic (CML) is a technique for transmitting digital data, in which current is steered between two alternate paths depending on whether a logic zero or a logic one is being represented. CML can be used for PCB-level interconnects and connections between IC modules for transmission of digital data at high speeds. CML transmission lines between a source and a destination are generally terminated at the destination with a termination resistance of 50Ω, which may be matched to the characteristic impedance of the transmission line.

A maximum achievable frequency for CML transmissions tends to be limited by parasitic and pad capacitances. Particularly when a digital signal is transmitted near to an upper frequency limit, a small distortion in duty cycle in a transmitted signal can result in a substantial distortion in the duty cycle of a received signal. This problem is usually mitigated using equalization techniques, but these can consume substantial amounts of power and chip area. Ensuring that a duty cycle of nominally 50% is maintained at the receiver side can therefore be a challenge especially for high frequency transmissions.

### Summary

According to a first aspect there is provided a current mode logic (CML) transmission system comprising: a transmission channel having first and second transmission paths; a transmitter connected to the respective first and second transmission paths at a first end of the transmission channel; a receiver having first and second adjustable receiver termination resistances connected to the respective first and second transmission paths at a second end of the transmission channel; and a control system configured to: measure a duty cycle of a received signal from the receiver; and provide first and second termination resistance control signals to the respective first and second adjustable receiver termination resistances to adjust a balance of the termination resistance control signals dependent on a comparison between the measured duty cycle and a nominal duty cycle.

The transmitter may comprise first and second adjustable transmitter termination resistances.

The nominal duty cycle may be around 50%.

The comparison may be between the measured duty cycle and a range around the nominal duty cycle defined by upper and lower duty cycle thresholds.

The range may be within around 5% or around 10% of the nominal duty cycle.

The control system may be configured to adjust the balance of termination resistance control signals by: increasing the first adjustable receiver termination resistance and decreasing the second adjustable receiver termination resistance if the measured duty cycle is above the nominal duty cycle; and decreasing the first adjustable receiver termination resistance and increasing the second adjustable receiver termination resistance if the measured duty cycle is below the nominal duty cycle.

The control system may be configured to adjust the balance of termination resistance control signals by: increasing the first adjustable receiver termination resistance and decreasing the second adjustable receiver termination resistance if the measured duty cycle is above the upper duty cycle threshold; and decreasing the first adjustable receiver termination resistance and increasing the second adjustable receiver termination resistance if the measured duty cycle is below the lower duty cycle threshold.

The first and second termination resistances may be increased or decreased by the same amount.

The control system may comprise: a duty cycle detector configured to measure the duty cycle of the received signal from the receiver and output a measured duty cycle; a first comparator configured to compare the measured duty cycle from the duty cycle detector to an upper duty cycle threshold; a second comparator configured to compare the measured duty cycle from the duty cycle detector to a lower duty cycle threshold; digital logic configured to receive outputs from the first and second comparators and provide a digital signal output; a finite state machine configured to receive the digital signal output from the digital logic and provide the first and second termination resistance control signals to the respective first and second adjustable receiver termination resistances of the receiver.

According to a second aspect there is provided a method of operating a CML transmission system comprising: a transmission channel having first and second transmission paths; a transmitter connected to the respective first and second transmission paths at a first end of the transmission channel; a receiver having first and second adjustable receiver termination resistances connected to the respective first and second transmission paths at a second end of the transmission channel; and a control system, the method comprising the control system: measuring a duty cycle of a received signal from the receiver; and providing first and second termination resistance control signals to the respective first and second adjustable receiver termination resistances to adjust a balance of the termination resistance control signals dependent on a comparison between the measured duty cycle and a nominal duty cycle.

The comparison may be between the measured duty cycle and a range around the nominal duty cycle defined by upper and lower duty cycle thresholds.

The control system may adjust the balance of termination resistance control signals by: increasing the first adjustable receiver termination resistance and decreasing the second adjustable receiver termination resistance if the measured duty cycle is above the nominal duty cycle; and decreasing the first adjustable receiver termination resistance and increasing the second adjustable receiver termination resistance if the measured duty cycle is below the nominal duty cycle.

The control system may adjust the balance of termination resistance control signals by: increasing the first adjustable receiver termination resistance and decreasing the second adjustable receiver termination resistance if the measured duty cycle is above the upper duty cycle threshold; and decreasing the first adjustable receiver termination resistance and increasing the second adjustable receiver termination resistance if the measured duty cycle is below the lower duty cycle threshold.

The first and second termination resistances may be increased or decreased by the same amount.

A difference between the nominal duty cycle and the upper and lower thresholds may be between around 1% and 10%.

These and other aspects of the invention will be apparent from, and elucidated with reference to, the embodiments described hereinafter.

### Brief description of Drawings

Embodiments will be described, by way of example only, with reference to the drawings, in which:
Figure 1 is a series of plots of voltage signals over time for an example transmitted and received clock signal;
Figure 2 is a schematic diagram of an end-to-end high-speed communication link;
Figure 3 is a schematic diagram of an example termination resistance control circuit for a CML transmitter;
Figure 4 is a schematic circuit diagram of an example termination resistance circuit for a CML transmitter;
Figure 5 is a schematic diagram of an example CML receiver circuit with offset control and adjustable termination resistances;
Figure 6 is a schematic diagram of an example CML transmission system with a termination resistance control system;
Figure 7 is a flow diagram illustrating operation of the termination resistance control system of Figure 6 for receiver termination resistance control;
Figure 8 is a flow diagram illustrating operation of the termination resistance control system of Figure 6 with further adjustments;
Figure 9 is a series of plots of voltage signals over time for an example high frequency transmitted and received clock signal with termination resistance equalization; and
Figure 10 is a series of plots of voltage signals over time for an example transmitted and received clock signal at low frequency with termination resistance equalization.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

Disclosed herein is a low power and wide frequency range duty cycle correction system and method that can be implemented without occupying significant additional area and without compromising on bandwidth of transmitter and receiver analog circuits. As described herein, a measured duty cycle can be corrected primarily through independent control of termination resistances at the receiver optionally along with additional offset control bits in the receiver. Adjustments can also be made to the transmitter in some examples. The scheme can for example be used to increase the maximum operating frequency of a CML transmission system without requiring additional power.

The bandwidth of high-speed transmission lines is usually limited by the pad capacitance, together with ESD protection at the transmitter side and the load at the receiver side. It becomes more difficult to achieve a higher bandwidth with higher load capacitances as ESD requirements generally cannot be compromised. When the transmitter side is operated at a frequency near or above the bandwidth, the output swing reduces as the slew is higher. In this scenario, if for example the input duty cycle departs from an ideal 50%, a differential swing at the output is different while sending "0" to when sending "1". This creates a non-ideal input for the receiver and results in a higher degradation of duty cycle in the receiver. Disclosed herein is an architecture in which the differential terminations can be tuned in the receiver, and optionally further adjustments made in the transmitter, to maintain the output swing equal while transmitting "0" or "1" in a bandwidth limited design.

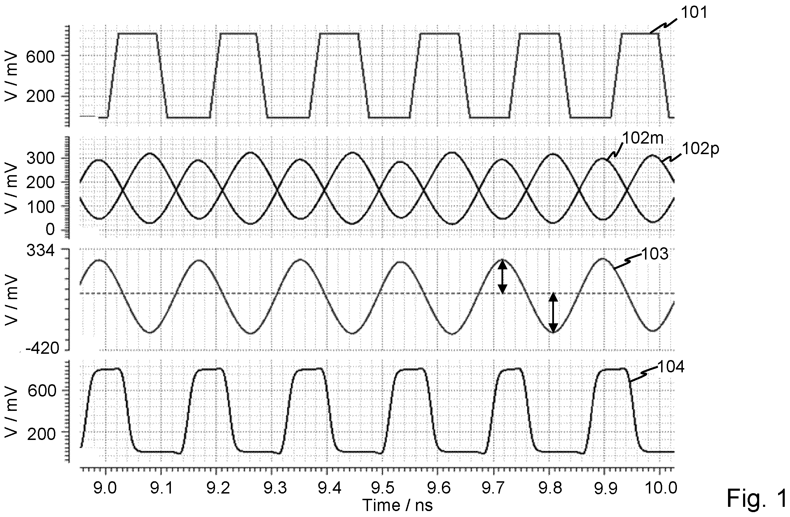

Figure 1 illustrates an example series of voltage signals showing duty cycle degradation in a bandwidth-limited transmitter. An input digital signal 101, in this case a clock signal having a period of around 0.2 ns (i.e. a frequency of around 5 GHz) has a duty cycle of around 48%, i.e. close to an ideal 50% duty cycle. This translates into a pair of alternating voltage signals 102p, 102m on first and second transmission paths of a CML transmission channel. Due to the departure of the input duty cycle from ideal, the voltage signals 102p, 102m are offset relative to each other. This results in an output voltage signal 103 that has a mismatch between transmission of a "1" compared to a "0", as indicated by a difference in amplitude between positive and negative sides of the output voltage signal 103. This translates into a higher duty cycle degradation in the receiver side, as indicated in the output signal 104 from the receiver. This degradation can be further aggravated due to mismatches between the transmitter and receiver sides and statistical variations in component values due to process variations.

Equalization techniques can be implemented to solve these issues at high frequencies. Disadvantages of such techniques, however, can include a higher static current consumption, increased supply noise, complex implementation and an increased chip area being required. These can be particularly problematic for applications where both high frequency transmissions and low power are required.

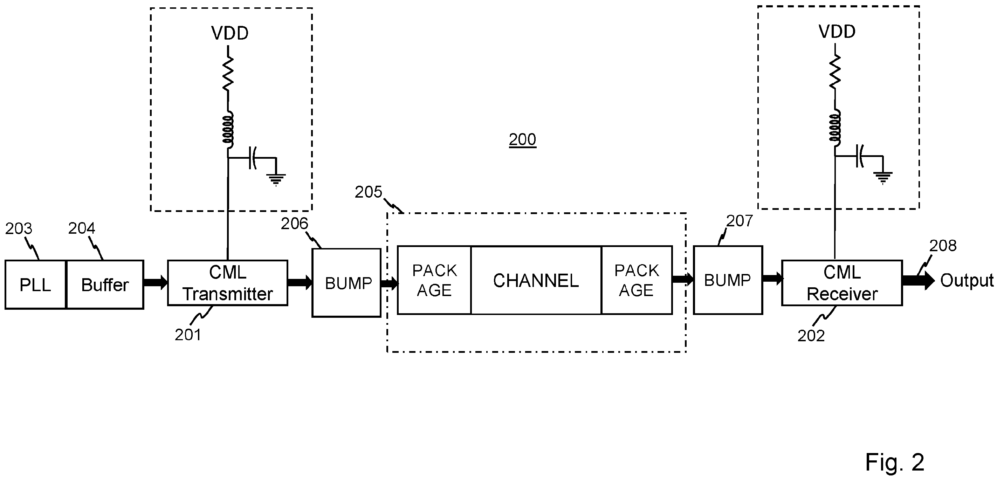

Figure 2 illustrates schematically an example CML transmission system 200 arranged to transmit a digital signal from a transmitter 201 to a receiver 202. The transmitter 201 and receiver 202 are both powered from a supply voltage VDD. The transmitter 201 is provided a digital signal, in this case a clock signal, from a PLL 203 via a buffer 204. The transmitter 201 provides a transmitted signal to a transmission channel 205 via a bump 206 at a first end of the transmission channel 205. The receiver 202 receives a signal via a further bump 207 at a second end of the transmission channel 205 and provides an output signal 208 that should ideally replicate the input digital signal provided to the transmitter 201. Each of the components from the buffer 204 through to the receiver 202 introduces some degradation to the signal, resulting in the duty cycle of the output signal 208 departing from that of the input signal provided by the PLL 203.

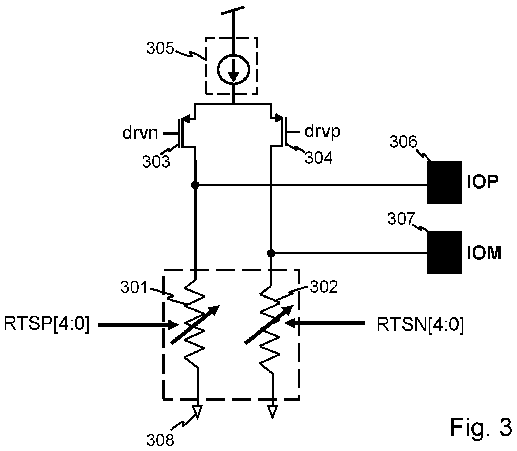

Each of the transmitter 201 and receiver 202 comprises a termination resistance connecting each transmission path to ground (or a common connection). The termination resistance for a CML transmission system is typically around 50Ω, matching the impedance of the transmission channel. Figure 3 illustrates an example output side of a CML transmitter in which first and second termination resistances 301, 302 are connected between respective first and second switches 303, 304 and ground 308, the switches 303, 304 being driven by drive signals drvn, drvp so that a constant current source 305 feeds a current through respective first and second pads 306, 307 connected to respective transmission paths at a first end of the transmission channel. Each termination resistance 301, 302 is adjustable, in that a value of each termination resistance 301, 302 is set by a respective termination resistance control signal RTSP, RTSN. In this example, the termination resistance control signals RTSP, RTSN are five-bit digital signals to control switches connecting a combination of resistors that together define the termination resistance.

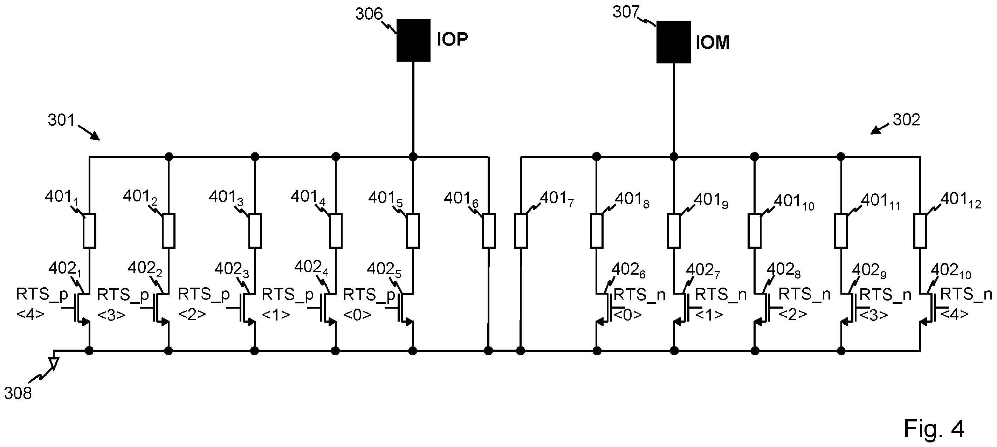

An example arrangement of resistors 401₁₋₁₂ and switches 402₁₋₁₀ making up first and second adjustable termination resistances 301, 302 is illustrated in Figure 4. Individual bits of the five-bit termination resistance control signals RTSP, RTSN control operation of switches 402₁₋₁₀ that connect or disconnect respective resistors 401_{1-5,8-12} between output pads 306, 307 and ground 308, defining the values of each termination resistance 301, 302. By selecting the values of each of the resistors 401₁₋₁₂ the termination resistance of each side can be adjusted between a desired range with a precision determined by the number of bits in the control signals RTSP, RTSN. For a CML transmission system, the range may for example be from around 30Ω to around 75Ω, i.e. either side of a nominal 50Ω to match the characteristic impedance of the transmission line.

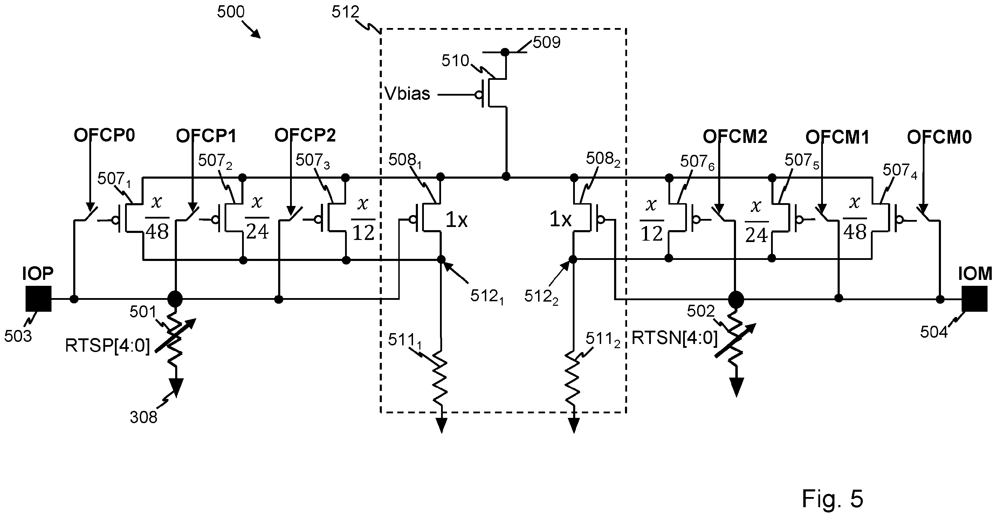

Figure 5 illustrates an example arrangement for a receiver input circuit 500 in which adjustable termination resistances 501, 502 are connected to respective input pads 503, 504 that connect the receiver input circuit 500 to a second end of a CML transmission channel. The adjustable termination resistances 501, 502 may be similar to those in Figure 4. In addition, the receiver input circuit 500 may be configured to provide a controllable offset to the input signal received via the input pads 503, 504. An offset control signal in the form of multi-bit signals OFCP0-2, OFCM0-2 are provided to control whether the input signal received via each pad 503, 504 is provided to input terminals of a plurality of offset control transistors 507₁₋₆, which are connected in parallel with an input transistor 508_{1,2}. A common bias transistor 510 is connected between the supply voltage line 509 and a first output of each of the input transistors 508_{1,2}. A second output terminal of each of the input transistors 508_{1,2} is connected to ground 308 via a respective resistor 511_{1,2}. The input resistors 511_{1,2}, input transistors 508_{1,2} and bias transistor 510 together make up a first stage preamplifier 512 of the CML receiver. Output nodes 512_{1,2} of the first stage preamplifier 512 provide connections for a second stage differential amplifier (not shown).

In an example implementation, the receiver input circuit 500 may be designed to receive a clock signal with a 100mV minimum swing and at a frequency of 5.5GHz. The clock signal is then converted to a CMOS signal form. When there is a duty cycle degradation at the receiver input the differential swing becomes smaller. As the input swing gets closer to the input sensitivity voltage, the duty cycle degradation increases. Conventional offset correction can in such cases become less effective. It has been observed that duty cycle distortion become worse when the input of the receiver circuit has a duty cycle of less than 45% (or conversely greater than 55%). The reduced pulse width at the receiver input circuit 500 demands a further extra bandwidth from the receiver, which conventionally would require redesign of the receiver with additional power requirements. In place of this, a correction can be done using the adjustable termination resistances 501, 502. This may be done at the input of the receiver only, which helps to increase the range of duty cycle correction.

Test results from varying the first and second adjustable receiver termination resistances are summarised in Table 1 below. From a receiver output duty cycle of around 24% with equal termination resistance of 22 Ω, the duty cycle at the receiver output was increased to around 52% by reducing the first termination resistance (RTS-P) and increasing the second termination resistance (RTS-N), in this case by equal amounts. This result shows that the duty cycle can be adjusted by adjusting a balance of the termination resistances, which can be done by adjusting a balance of the termination resistance control signals.

**Table 1 - Variation in duty cycle with varying receiver termination resistance.**

| **RTS-P** | **RTS-N** | **Duty Cycle Tx output** | **Duty Cycle Rx input** | **Duty Cyle Rx output** |
|---|---|---|---|---|
| 22 Ω | 22 Ω | 44.12% | 42% | 23.55% |
| 17 Ω | 27 Ω | 47.7% | 47.86% | 48.38% |
| 16 Ω | 28 Ω | 48.4% | 49.08% | 51.85% |

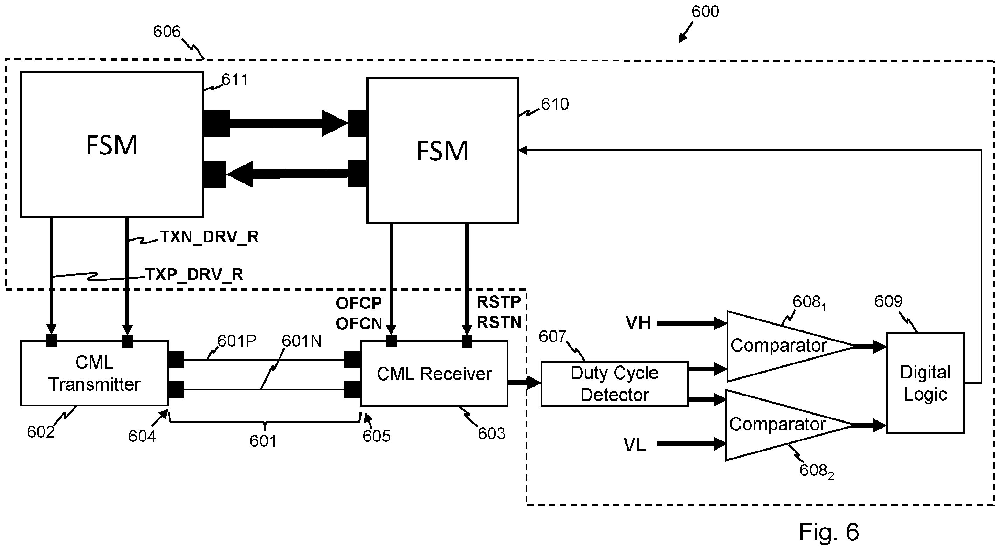

In practice, a termination resistance control system can be implemented to monitor a received signal at the second end of a CML transmission channel and to provide first and second termination resistance control signals to respective first and second adjustable receiver termination resistances. An example CML transmission system 600 incorporating such a termination resistance control system 606 is illustrated schematically in Figure 6. The CML transmission system 600 comprises a transmission channel 601 having first and second transmission paths 601P, 601N. A transmitter 602 is connected to the respective first and second transmission paths 601P, 601N at a first end 604 of the transmission channel 601. A receiver 603 comprises first and second adjustable receiver termination resistances 501, 502 (as in Figure 5) connected to the respective first and second transmission paths 601P, 601N at a second end 605 of the transmission channel 601.

A control system 606 is configured to measure a duty cycle of a received signal from the receiver 603 and provide first and second termination resistance control signals RSTP, RSTN to the respective first and second adjustable receiver termination resistances 501, 502 to adjust a balance of the termination resistance control signals RSTP, RSTN dependent on a comparison of the measured duty cycle to a nominal duty cycle. The nominal duty cycle may for example be around 50%. The comparison may be a comparison between the measured duty cycle and a range around, i.e. either side of, the nominal duty cycle. The range may for example be within around 5% or within around 10% of the nominal duty cycle, i.e. between around 45% and 55% of between around 40% and 60%.

The control system 606 may be configured to adjust the balance of termination resistance control signals RSTP, RSTN to increase the first adjustable receiver termination resistance 501 and decrease the second adjustable receiver termination resistance 502 if the measured duty cycle is above the nominal duty cycle, or above the range around the nominal duty cycle, and to decrease the first adjustable receiver termination resistance 501 and increase the second adjustable receiver termination resistance 502 if the measured duty cycle is below the nominal duty cycle, or below the range around the nominal duty cycle. In a particular example, the control system 606 may be configured to adjust the balance of the termination resistance control signals RSTP, RSTN if the measured duty cycle is either above an upper limit of the range or below a lower limit of the range, the balance being adjusted to bring the duty cycle back towards the nominal duty cycle. The upper limit may for example be around 55% and the lower limit around 45%.

The example control system 606 in Figure 6 comprises a duty cycle detector 607, a pair of comparators 608_{1,2}, digital logic 609 and a first finite state machine (FSM) 610 for providing control signals to the CML receiver 603. A second finite state machine 611 may also be provided for providing control signals to the CML transmitter 602. The duty cycle detector 607 receives a signal from the CML receiver 603 and measures a duty cycle of the signal. The measured duty cycle is provided to first and second comparators 608_{1,2}, which compare the measured duty cycle to an upper threshold VH provided to the first comparator 608₁ and to a lower threshold VL provided to the second comparator 608₂. Outputs from each of the comparators 608_{1,2} are provided to digital logic 609, which determines from these outputs a digital signal to provide to the first FSM 610. The first FSM 610 determines from this digital signal how to adjust the termination resistance control signals RSTP, RSTN provided to the CML receiver 603. The first FSM 610 may also provide offset control signals OFCP, OFCN to the CML receiver 603. The first FSM 610 may communicate with the second FSM 611 (if present) to enable the second FSM 611 to provide transmitter control signals TXN_DRV_R, TXP_DRV_R to the CML transmitter 602.

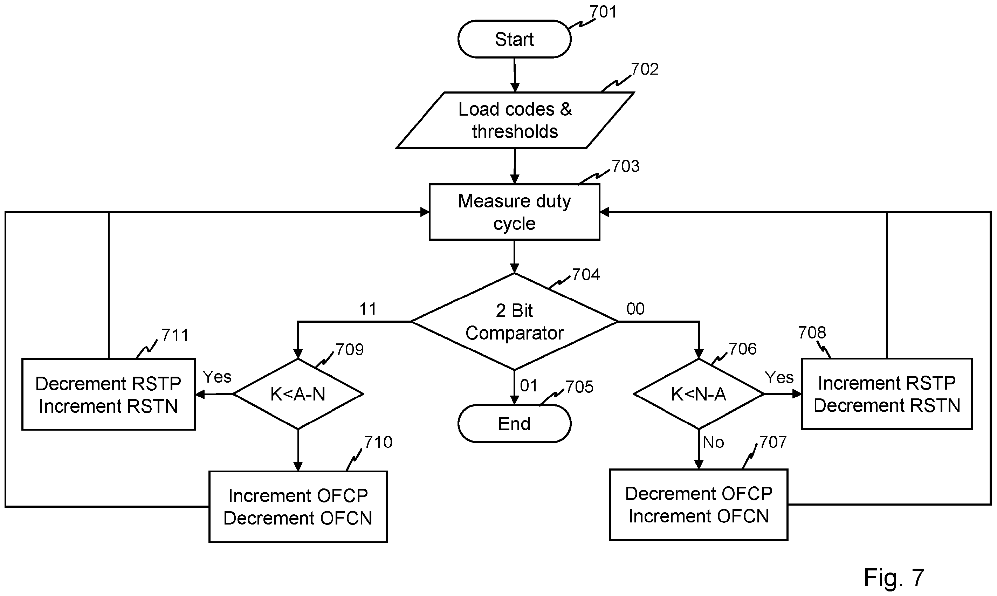

Figure 7 is a flow diagram illustrating an example method of operation of the control system 606 of Figure 6, in which the control system 606 operates to control the termination resistances of the receiver 603. The method starts (step 701) and in step 702 default codes for the receiver termination resistances are loaded (e.g. RSTP=X, RSTN=Y, where X and Y are the initial default codes).

Receiver offset codes, if present, are also loaded (e.g. OFCP=A, OFCN=B, where A and B are the initial default codes). Thresholds are also defined, in this case where M=X and N=A, a threshold being defined as K, which is used in further steps described below.

At step 703, the duty cycle detector 607 measures the duty cycle of the signal from the receiver 603 and provides a duty cycle measure Vmes to the comparators 608_{1,2}. The comparators compare Vmes to the high and low thresholds VH, VL, and together output a two-bit digital signal to the digital logic 609. For example, if Vmes>VH>VL, the output from the comparators is 11, if VH>Vmes>VL, the output is 01 and if Vmes<VL<VH, the output is 00. An output of 10 is considered invalid.

At step 704, the digital logic 609 checks the value of the two-bit output from the comparators 608_{1,2}. If the output is 01, i.e. the measured duty cycle is between the higher and lower thresholds VH, VL, the process ends at step 705 as no change is required. If at step 704 the output is 00, i.e. the measured duty cycle is below the lower duty cycle threshold VL, at step 706 a check is made to determine whether the threshold K is less than N-A. If so, at step 708 RSTP is incremented (X=X+1) and RSTN is decremented (Y=Y-1). Also at step 708 the receiver offset codes (if used) are reset such that for OFCP, A=N, and for OFCN, B=N. If at step 706 K is not less than N-A, at step 707 the offset codes are changed such that OFCP is decremented (A=A-1) and OFCN is incremented (B=B+1). The process then returns to the measurement step 703 and repeats.

If, at step 704, the output is 11, i.e. the measured duty cycle is above the higher duty cycle threshold VH, at step 709 a check is made to determine whether the threshold K is less than A-N. If so, at step 711 RSTP is decremented (X=X-1) and RSTN is incremented (Y=Y+1). Also at step 711 the receiver offset codes (if used) are reset such that for OFCP, A=N, and for OFCN, B=N. If at step 709 K is not less than A-N, at step 710 the offset codes are changed such that OFCP is incremented (A=A+1) and OFCN is decremented (B=B-1). The process then returns to the measurement step 703 and repeats.

The above process from step 703 can be repeated until the two-bit comparator output is 01, i.e. the measured duty cycle is between the higher and lower duty cycle thresholds and no further adjustments are required.

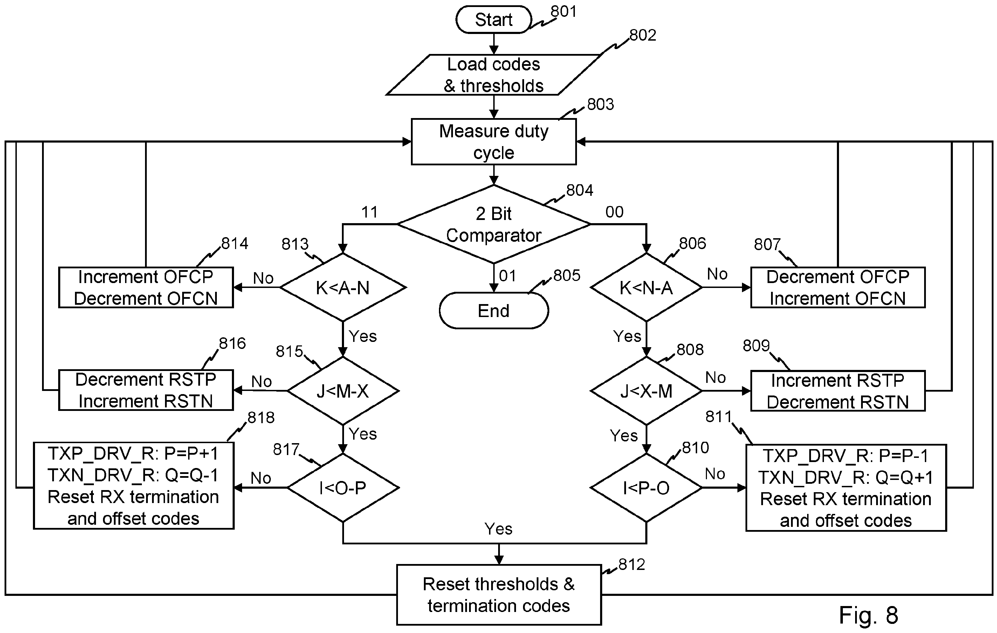

Figure 8 is a further flow diagram illustrating an example method of operation of the control system 606 in which both the receiver 603 and transmitter 602 are controlled. The method starts (step 801) and at step 802 default codes for the receiver termination resistances are loaded (e.g. RSTP=X, RSTN=Y, where X and Y are default codes). Receiver offset codes, if present, are also loaded (e.g. OFCP=A, OFCN=B, where A and B are default codes). Transmitter termination codes are also loaded, e.g. TXP_DRV_R=P, TXN_DRV_R=Q, where P and Q are default codes. Thresholds are also defined, in this case where M=X, N=A and O=P, thresholds are defined as K, J and I, which are used in further steps described below. K and J are defined as receiver offset and termination resistance thresholds, while I is defined as a transmitter driver threshold.

At step 803, the duty cycle detector 607 measures the duty cycle of the signal from the receiver 603 and provides a duty cycle measure Vmes to the comparators 608_{1,2}. The comparators compare Vmes to the higher and lower duty cycle thresholds VH, VL, and output a two-bit digital signal to the digital logic 609. For example, if Vmes>VH>VL, the output is 11, if VH>Vmes>VL, the output is 01 and if Vmes<VL<VH, the output is 00. An output of 10 is considered invalid.

At step 804, the digital logic 609 checks the value of the two-bit output from the comparators 608_{1,2}. If the output is 01, i.e. the measured duty cycle is between the higher and lower duty cycle thresholds VH, VL, the process ends at step 805 as no change (or no further change) is required. If at step 804 the output is 00, i.e. the measured duty cycle is below the lower duty cycle threshold VL, at step 806 a check is made to determine whether the threshold K is less than N-A. If not, at step 807 OFCP is decremented, i.e. A=A-1, and OFCN is incremented, i.e. B=B+1. The process then returns to step 803.

If, at step 806, K is less than N-A, at step 808 a check is made as to whether J is less than X-M. If not, at step 809 RSTP is incremented, i.e. X=X+1, and RSTN is decremented, i.e. Y=Y-1. The receiver offset codes (if used) are also reset such that for OFCP, A=N, and for OFCN, B=N. The process then returns to step 803.

If, at step 808, J is less than X-M, at step 810 a check is made as to whether I is less than P-O. If not, at step 811 the transmitter driver codes are incremented and decremented, i.e. P=P-1 and Q=Q+1 for transmitter control signals TXP_DRV_R, TXN_DRV_R provided to the CML transmitter 602.

If, at step 810, I is not less than P-O, at step 812 the receiver offset and termination resistance thresholds K and J are incremented, i.e. K=K+n and J=J+n, and the transmitter threshold is incremented, i.e. I=I+n, where n is an integer defining an update step for each threshold. The transmitter termination codes TXP_DRV_R and TXN_DRV_R are reset to zero, i.e. P=0 and Q=0. The receiver termination codes are also reset such that for RSTP, X and Y are both set equal to M, and the receiver offset codes for OFCP and OFCN, A and B, are both set to N. The process then returns to step 803.

If, at step 804, the output is 11, i.e. the measured duty cycle is above the upper duty cycle threshold VH, at step 813 a check is made to determine whether the threshold K is less than A-N. If not, at step 814 OFCP is incremented, i.e. A=A+1, and OFCN is decremented, i.e. B=B-1. The process then returns to step 803.

If, at step 813, K is less than A-N, at step 815 a check is made as to whether J is less than M-X. If not, at step 816 RSTP is decremented, i.e. X=X-1, and RSTN is incremented, i.e. Y=Y+1. The receiver offset codes (if used) are also reset such that for OFCP, A=N, and for OFCN, B=N. The process then returns to step 803.

If, at step 815, J is less than M-X, at step 817 a check is made as to whether I is less than O-P. If not, at step 818 the transmitter driver codes are incremented and decremented, i.e. P=P+1 and Q=Q-1 for transmitter control signals TXP_DRV_R, TXN_DRV_R provided to the CML transmitter 602.

If, at step 817, I is not less than O-P, at step 812 the receiver offset and termination resistance thresholds K and J are incremented, i.e. K=K+n and J=J+n, and the transmitter threshold is incremented, i.e. I=I+n, where n is an integer defining an update step for each threshold. The transmitter termination codes TXP_DRV_R and TXN_DRV_R are reset to zero, i.e. P=0 and Q=0. The receiver termination codes are also reset such that for RSTP, X and Y are both set equal to M, and the receiver offset codes for OFCP and OFCN, A and B, are both set to N. The process then returns to step 803.

The above process from step 803 onwards can repeat until the two-bit comparator output is 01, i.e. the measured duty cycle is between the higher and lower duty cycle thresholds and no further adjustments are required.

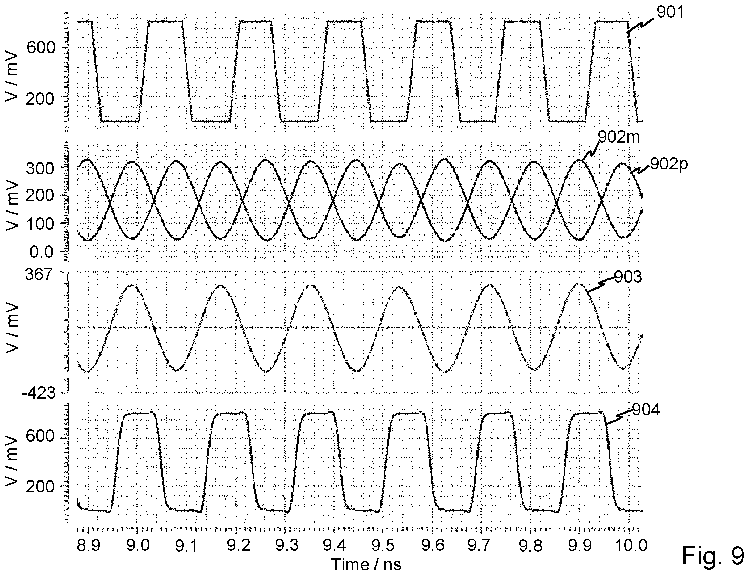

Figure 9 illustrates a series of voltage signals showing the effect of adjusting the balance of termination resistance control signals in correcting for a high frequency transmitted signal with a duty cycle that is non-optimal. The input signal 901 exhibits a 48% duty cycle, which results in imbalanced signals 902m, 902p transmitted along the CML transmission channel. By adjusting the receiver termination resistances accordingly, the output voltage signal 903 is balanced, resulting in an improved duty cycle at the receiver output 904.

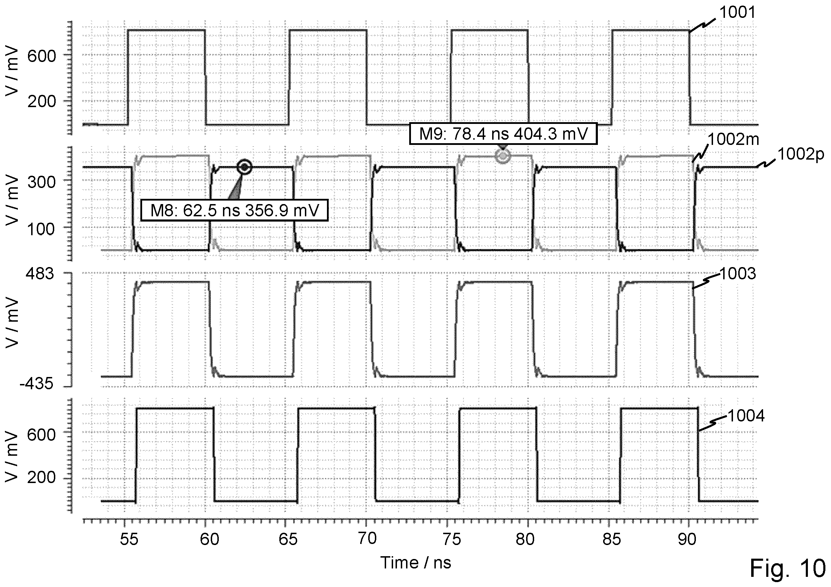

Figure 10 illustrates a further series of voltage signals showing how adjusting the balance of termination resistance control signals does not affect a low frequency transmitted signal. The input signal 1001 exhibits a 48% duty cycle, which results in imbalanced signals 1002m, 1002p transmitted along the CML transmission channel. Adjusting the receiver termination resistances does not affect the output voltage signal 1003 and the receiver output 1004 duty cycle is unchanged at 48%.

From reading the present disclosure, other variations and modifications will be apparent to the skilled person. Such variations and modifications may involve equivalent and other features which are already known in the art of digital communication transmission, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A current mode logic, CML, transmission system (600) comprising:
a transmission channel (601) having first and second transmission paths (601P, 601N);
a transmitter (602) connected to the respective first and second transmission paths (601P, 601N) at a first end (604) of the transmission channel (601);
a receiver (603) having first and second adjustable receiver termination resistances (501, 502) connected to the respective first and second transmission paths (601P, 601N) at a second end (605) of the transmission channel (601); and
a control system (606) configured to:
measure a duty cycle of a received signal from the receiver (603); and
provide first and second termination resistance control signals (RSTP, RSTN) to the respective first and second adjustable receiver termination resistances (501, 502) to adjust a balance of the first and second adjustable receiver termination resistances (501, 502) dependent on a comparison between the measured duty cycle and a nominal duty cycle.

2. The CML transmission system (600) of claim 1, wherein the transmitter (602) comprises first and second adjustable transmitter termination resistances (301, 302).

3. The CML transmission system (600) of claim 1 or claim 2, wherein the nominal duty cycle is around 50%.

4. The CML transmission system (600) of any preceding claim, wherein the comparison is between the measured duty cycle and a range around the nominal duty cycle defined by upper and lower duty cycle thresholds.

5. The CML transmission system (600) of claim 4, wherein the range is within around 5% or around 10% of the nominal duty cycle.

6. The CML transmission system (600) of any preceding claim, wherein the control system (606) is configured to adjust the balance of termination resistance control signals (RSTP, RSTN) by:
increasing the first adjustable receiver termination resistance (501) and decreasing the second adjustable receiver termination resistance (502) if the measured duty cycle is above the nominal duty cycle; and
decreasing the first adjustable receiver termination resistance (501) and increasing the second adjustable receiver termination resistance (502) if the measured duty cycle is below the nominal duty cycle.

7. The CML transmission system (600) of claim 4 or claim 5, wherein the control system (606) is configured to adjust the balance of termination resistance control signals (RSTP, RSTN) by:
increasing the first adjustable receiver termination resistance (501) and decreasing the second adjustable receiver termination resistance (502) if the measured duty cycle is above the upper duty cycle threshold; and
decreasing the first adjustable receiver termination resistance (501) and increasing the second adjustable receiver termination resistance (502) if the measured duty cycle is below the lower duty cycle threshold.

8. The CML transmission system (600) of claim 6 or claim 7, wherein the first and second termination resistances are increased or decreased by the same amount.

9. The CML transmission system (600) of any preceding claim, wherein the control system (606) comprises:
a duty cycle detector (607) configured to measure the duty cycle of the received signal from the receiver (603) and output a measured duty cycle;
a first comparator (608₁) configured to compare the measured duty cycle from the duty cycle detector (607) to an upper duty cycle threshold (Vth1);
a second comparator (608₂) configured to compare the measured duty cycle from the duty cycle detector (607) to a lower duty cycle threshold (Vth1);
digital logic (609) configured to receive outputs from the first and second comparators (608_{1,2}) and provide a digital signal output;
a finite state machine (610) configured to receive the digital signal output from the digital logic (609) and provide the first and second termination resistance control signals (RSTP, RSTN) to the respective first and second adjustable receiver termination resistances (501, 502) of the receiver (603).

10. A method of operating a CML transmission system (600) comprising:
a transmission channel (601) having first and second transmission paths (601P, 601N);
a transmitter (602) connected to the respective first and second transmission paths (601P, 601N) at a first end (604) of the transmission channel (601);
a receiver (603) having first and second adjustable receiver termination resistances (501, 502) connected to the respective first and second transmission paths (601P, 601N) at a second end (605) of the transmission channel (601); and
a control system (606),
the method comprising the control system (606):
measuring a duty cycle of a received signal from the receiver (603); and
providing first and second termination resistance control signals (RSTP, RSTN) to the respective first and second adjustable receiver termination resistances (501, 502) to adjust a balance of the first and second adjustable receiver termination resistances (501, 502) dependent on a comparison between the measured duty cycle and a nominal duty cycle.

11. The method of claim 10, wherein the comparison is between the measured duty cycle and a range around the nominal duty cycle defined by upper and lower duty cycle thresholds.

12. The method of claim 10, wherein the control system (606) adjusts the balance of the first and second adjustable receiver termination resistances (501, 502) by:
increasing the first adjustable receiver termination resistance (501) and decreasing the second adjustable receiver termination resistance (502) if the measured duty cycle is above the nominal duty cycle; and
decreasing the first adjustable receiver termination resistance (501) and increasing the second adjustable receiver termination resistance (502) if the measured duty cycle is below the nominal duty cycle.

13. The method of claim 11, wherein the control system (606) adjusts the balance of the first and second adjustable receiver termination resistances (501, 502) by:
increasing the first adjustable receiver termination resistance (501) and decreasing the second adjustable receiver termination resistance (502) if the measured duty cycle is above the upper duty cycle threshold; and
decreasing the first adjustable receiver termination resistance (501) and increasing the second adjustable receiver termination resistance (502) if the measured duty cycle is below the lower duty cycle threshold.

14. The method of claim 12 or claim 13, wherein the first and second adjustable receiver termination resistances are increased or decreased by the same amount.

15. The method of any one of claims 11 to 14, wherein a difference between the nominal duty cycle and the upper and lower thresholds is between around 1% and 10%.
